# EUROPÄISCHE PATENTSCHRIFT

(11) **EP 1 269 631 B1**
(45) Veröffentlichungstag und Bekanntmachung des Hinweises auf die Patenterteilung: **21.02.2007**
(21) Anmeldenummer: 00991549.7
(22) Anmeldetag: 22.12.2000
(51) Int. Cl.: H03L 7/10

(54) **VERFAHREN ZUM BETRIEB EINES OSZILLATORS SOWIE ELEKTRISCHE SCHALTUNGSANORDNUNG DAFÜR UND PHASENREGELSCHLEIFE**
METHOD FOR OPERATING AN OSCILLATOR AND AN ELECTRIC CIRCUIT ARRANGEMENT AND A PHASE-LOCKED LOOP
PROCEDE PERMETTANT DE FAIRE FONCTIONNER UN OSCILLATEUR, CIRCUIT ELECTRIQUE ET BOUCLE A PHASE ASSERVIE ET RELATIFS

(30) Priorität: 03.04.2000 DE 10016499
(43) Veröffentlichungstag der Anmeldung: 02.01.2003
(73) Patentinhaber: SIEMENS AKTIENGESELLSCHAFT, 80333 München (DE)
(72) Erfinder: SCHECHINGER, Alois, 85283 Wolnzach (DE); WANNENMACHER, Volker, 81369 München (DE)
(86) Internationale Anmeldenummer: PCT/DE2000/004598
(87) Internationale Veröffentlichungsnummer: WO 2001/076072

(56) Entgegenhaltungen:
- EP-A- 0 561 257
- EP-A- 0 829 968
- DE-A- 3 938 292
- US-A- 5 359 300

## Beschreibung

Die Erfindung betrifft ein Verfahren zum Betrieb eines spannungsgesteuerten Oszillators, insbesondere in einem portablen Kommunikationsgerät, wobei dem Oszillator eine variable Steuerspannung zugeführt wird, die einer Betriebsspannung, vorzugsweise aus einer konstanten Spannungsquelle, entnommen wird.

Weiterhin betrifft die Erfindung eine elektrische Schaltungsanordnung zur Steuerung eines spannungsgesteuerten Oszillators, wobei der Oszillator mindestens einen Steuereingang für eine variable Steuerspannung und mindestens einen Eingang für eine Betriebsspannung aufweist. Darüber hinaus betrifft die Erfindung eine Phasenregelschleife mit mindestens einem Detektor, der eine variable Steuerspannung erzeugt, einer Filteranordnung und einem Oszillator, wobei der Oszillator mindestens einen Steuereingang für die variable Steuerspannung und mindestens einen Eingang für eine Betriebsspannung aufweist.

In Geräten der Kommunikationstechnik werden zur Erzeugung hochfrequenter Sinusspannungen spannungsgesteuerte Oszillatoren verwendet. Über einen Steuereingang kann bei diesen Oszillatoren die Ausgangsfrequenz innerhalb eines gewissen Bereiches variiert beziehungsweise abgestimmt werden. Dabei ist die Größe dieses abstimmbaren Frequenzbereiches, der auch Ziehbereich genannt wird, dadurch festgelegt, welche minimale und maximale Spannung dem Steuereingang zugeführt werden kann. Hierbei ist die maximale Spannung durch die vorhandene Betriebsspannung gegeben.

Bei dem Betrieb von modernen Kommunikationsgeräten prallen oft zwei Forderungen aufeinander. Häufig erfordern diese Kommunikationsgeräte einen großen Ziehbereich des Oszillators, arbeiten aber gleichzeitig mit niedrigen Betriebsspannungen, zum Beispiel weil sie batteriebetrieben sind. Oszillatoren, die einen großen Ziehbereich mit nur geringer Steuerspannung abdecken, sind zwar herstellbar, leiden aber oft unter einer hohen Empfindlichkeit und unter schlechten Phasenrauscheigenschaften. Dies wird beim Einsatz solcher Oszillatoren in einer Phasenregelschleife oft noch verschärft.

Bisher wird zur Lösung zum Beispiel die Betriebsspannung des Gesamtgerätes durch Einsatz von DC-DC-Konvertern oder Ladungspumpen erhöht. Der Einsatz einer solchen Ladungspumpe in einer Schaltungsanordnung zur Steuerung eines spannungsgesteuerten Oszillators ist aus der veröffentlichten europäischen Patentanmeldung EP 0 829 968 A2 bekannt. Diese Lösung ist allerdings teuer, und es besteht die Gefahr von spektralen Unreinheiten durch NF-Störungen (NF = Niederfrequenz). Weiterhin werden mehrere Oszillatoren, von denen jeder nur einen Teil des gewünschten Frequenzbereiches abdeckt, verwendet. Diese Variante hat nun allerdings enorme Kosten zur Folge. In einem anderen Vorschlag werden geschaltete Oszillatoren, bei denen durch Umschaltung des Resonatorkreises, meist durch PIN-Dioden, ein Frequenzsprung erzeugt werden kann, verwendet. Hierbei ist aber der Entwurf und die Ausführung eines solchen Oszillators problematisch.

Es ist daher Aufgabe der Erfindung, ein Verfahren zur Verfügung zu stellen, das auf einfache und störungsfreie Weise eine Erweiterung des Ziehbereichs eines Oszillators ermöglicht. Weiterhin ist es Aufgabe der Erfindung, eine elektrische Schaltungsanordnung und eine Phasenregelschleife zur Durchführung des Verfahrens zur Verfügung zu stellen.

Die Aufgabe der Erfindung wird durch die jeweils unabhängigen Ansprüche gelöst.

Demgemäß schlagen die Erfinder vor, ein Verfahren zum Betrieb eines spannungsgesteuerten Oszillators, insbesondere in einem portablen Kommunikationsgerät, wobei dem Oszillator eine variable Steuerspannung zugeführt wird, die einer Betriebsspannung, vorzugsweise aus einer konstanten Spannungsquelle, entnommen wird, dahingehend weiterzuentwickeln, daß die variable Steuerspannung über einen Kondensator dem Oszillator zugeführt wird, und der variablen Steuerspannung in einer Betriebsphase bei Bedarf eine bestimmte Zusatzspannung zuaddiert wird, wobei die bestimmte Zusatzspannung in einer Bereitstellungsphase auf den Kondensator aufgebracht wird. Das Verfahren zum Betrieb des spannungsgesteuerten Oszillators gliedert sich also in eine Bereitstellungsphase und in eine Betriebsphase.

Vorteilhaft wird der Kondensator während der Bereitstellungsphase mit Hilfe einer an dem Kondensator anliegenden Ladespannung aufgeladen. Diese Ladespannung kann nun gleich der Betriebsspannung sein, so daß der Kondensator am Ende der Bereitstellungsphase eine Spannung (Zusatzspannung) trägt, die gleich der Betriebsspannung ist. Diese Zusatzspannung kann in der Betriebsphase zu der variablen Steuerspannung addiert werden, wodurch sich der Eingangsspannungsbereich des Oszillators um den Betrag der Zusatzspannung erhöht und sich hierdurch auch der Ziehbereich des Oszillators erweitert.

Eine vorteilhafte Weiterentwicklung des erfindungsgemäßen Verfahrens sieht vor, daß die Ladezeit durch Unterbrechung der an dem Kondensator anliegenden Ladespannung gesteuert wird. Die Unterbrechung des Ladevorganges des Kondensators in der Bereitstellungsphase kann zum Beispiel durch eine Steuervorrichtung bewirkt werden, die nach einer vorgegebenen Ladezeit einen Schalter öffnet und so die Aufladung des Kondensators unterbricht. Die nun an dem Kondensator anliegende Zusatzspannung ist kleiner als die Ladespannung beziehungsweise kleiner als die Betriebsspannung. Die Größe der Zusatzspannung am Kondensator ergibt sich somit aus der Dauer seiner Ladezeit. Diese Weiterentwicklung bewirkt, daß die Steuerspannung stufenlos erhöht werden kann, und somit auch der Ziehbereich des Oszillators über einen weiten Frequenzbereich abgestimmt werden kann.

Eine weitere Ausbildung des erfindungsgemäßen Verfahrens sieht vor, daß eine Zusatzspannung erzeugt wird, die gegenläufig der Ladespannung ausgebildet ist. Hierdurch wird ermöglicht, daß am Kondensator negative Zusatzspannungen anliegen und somit eine noch größere Variabilität erreicht werden kann.

In einer anderen Ausführung des erfindungsgemäßen Verfahrens, wenn nicht eine hohe, sondern eine niedrige Steuerspannung am Oszillator gewünscht ist, wird der Kondensator während der Bereitstellungsphase auf eine Spannung 0 entladen. In der Betriebsphase liegt somit am Oszillator die durch den Kondensator unveränderte Steuerspannung an.

Weiterhin wird der Kondensator während der Betriebsphase weder geladen noch entladen.

Darüber hinaus wird das erfindungsgemäße Verfahren dahingehend weiterentwickelt, daß der spannungsgesteuerte Oszillator in einer Phasenregelschleife verwendet wird. Es kann also auch hier in einer Bereitstellungsphase bei Bedarf eine bestimmte Zusatzspannung erzeugt werden, die in einer Betriebsphase zu der variablen Steuerspannung einer Phasenregelschleife addiert wird. Hierdurch erhöht sich der Eingangsspannungsbereich des Oszillators einer Phasenregelschleife und somit auch sein Ziehbereich.

Das erfindungsgemäße Verfahren eignet sich also im Wesentlichen für solche Oszillatoren oder Phasenregelschleifen, die nicht im Dauerbetrieb sind.

Die Erfinder schlagen weiterhin vor, eine elektrische Schaltungsanordnung zur Steuerung eines spannungsgesteuerten Oszillators, wobei der Oszillator mindestens einen Steuereingang für eine variable Steuerspannung und mindestens einen Eingang für eine Betriebsspannung aufweist, so weiterzuentwickeln, daß ein Kondensator in Serie zu dem Steuereingang des Oszillators vorgesehen ist, der mittels zumindest eines Schaltmittels zur Vorladung in einer Bereitstellungsphase an eine Ladespannung anschließbar ist und in einer Betriebsphase seine Spannung als eine Zusatzspannung an den Steuereingang des Oszillators legt. Wird eine in der Bereitstellungsphase erzeugte Zusatzspannung nun der Steuerspannung zuaddiert, kann dem Oszillator eine höhere Steuerspannung an seinem Steuereingang zur Verfügung gestellt werden.

In einer bevorzugten Ausgestaltung der erfindungsgemäßen elektrischen Schaltungsanordnung sind zur Vorladung des Kondensators mindestens drei, gegebenenfalls vier Schaltmittel vorgesehen.

Eine weitere vorteilhafte Ausgestaltung der erfindungsgemäßen elektrischen Schaltungsanordnung sieht vor, daß zumindest ein Schaltmittel mindestens einen Transistor oder mindestens eine Diode oder mindestens einen Schalter darstellt. Das Schaltmittel kann auch durch Kombinationen aus Transistor(en), Diode(n) und Schalter(n) realisiert sein.

Eine vorteilhafte Weiterentwicklung der elektrischen Schaltungsanordnung besteht darin, daß eine Steuervorrichtung zur Betätigung von mindestens einem Schaltmittel vorgesehen ist. Diese Steuervorrichtung unterbricht die Zusatzspannung des Kondensators durch eine Unterbrechung der Ladespannung.

Weiterhin kann die Steuervorrichtung derart ausgebildet sein, daß die Ladezeit variiert werden kann. So kann sie einen Zeitgeber enthalten, der bewirkt, daß die Steuervorrichtung nach einer vorgegebenen Ladezeit den Ladevorgang unterbricht. Beispielsweise kann die Ladung des Kondensators über einen Widerstand oder eine Stromquelle erfolgen, ehe die Steuervorrichtung einen Schalter öffnet und somit den Ladevorgang beendet. Weiterhin kann die Steuervorrichtung als Programmteil ausgebildet sein.

Da die meisten spannungsgesteuerten Oszillatoren nicht freilaufend betrieben werden, sondern Teil einer Phasenregelschleife sind, schlagen die Erfinder vor, eine Phasenregelschleife mit mindestens einem Detektor, der eine variable Steuerspannung erzeugt, einer Filteranordnung und einem Oszillator, wobei der Oszillator mindestens einen Steuereingang für die variable Steuerspannung und mindestens einen Eingang für eine Betriebsspannung aufweist, dahingehend weiterzuentwickeln, daß die oben genannte erfindungsgemäße elektrische Schaltungsanordnung vor dem Steuereingang des Oszillators vorgesehen ist. Die Filteranordnung ist beispielsweise ein Loopfilter, das für Gleichspannungen durchgängig ist.

In einer bevorzugten Weiterentwicklung der erfindungsgemäßen Phasenregelschleife verfügt der Detektor über zwei komplementär angeordnete Transistoren, die in einer Bereitstellungsphase die Funktion jeweils eines Schaltmittels übernehmen. Es werden also die in dem Detektor vorliegenden Transistoren zur Kondensatoraufladung mitbenutzt. Das heißt, je nach Stellung der Transistoren und eines weiteren Schalters kann der Kondensator sowohl geladen als auch entladen werden. Nach der Bereitstellungsphase, also in der Betriebsphase, arbeiten die Transistoren wieder als Phasendetektor.

Weitere Merkmale der Erfindung ergeben sich aus der nachfolgenden Beschreibung mehrerer Ausführungsbeispiele, unter Bezugnahme auf die Zeichnungen, wobei eine Betriebsspannung von 2,8 V und eine Steuerspannung von 0,3 V bis 2,2 V angenommen wird. Weiterhin wird angenommen, daß der Steuereingang des Oszillators nur vernachlässigbaren Stromverbrauch aufweist (gute Näherung für varaktorgesteuerte Oszillatoren). Es zeigen:
- Figur 1a:: eine erfindungsgemäße Schaltungsanordnung in einer Bereitstellungsphase mit Vorladung eines Kondensators;
- Figur 1b:: eine erfindungsgemäße Schaltungsanordnung in einer Betriebsphase nach Vorladung des Kondensators;
- Figur 2a:: eine erfindungsgemäße Schaltungsanordnung in der Bereitstellungsphase ohne Vorladung des Kondensators;
- Figur 2b:: eine erfindungsgemäße Schaltungsanordnung in der Betriebsphase ohne Vorladung des Kondensators;
- Figur 3a,b:: eine erfindungsgemäße Schaltungsanordnung mit einer alternativen Schalteranordnung in der Bereitstellungsphase;
- Figur 4a:: eine erfindungsgemäße Schaltungsanordnung in der Bereitstellungsphase für eine positive Vorladung des Kondensators;
- Figur 4b:: eine erfindungsgemäße Schaltungsanordnung in der Bereitstellungsphase für eine negative Vorladung des Kondensators;
- Figur 5a:: eine erfindungsgemäße Schaltungsanordnung mit einer variablen Vorspannung durch einen Widerstand;
- Figur 5b:: eine erfindungsgemäße Schaltungsanordnung mit einer variablen Vorspannung durch eine Stromquelle;
- Figur 6:: eine bekannte Phasenregelschleife;
- Figur 7:: eine erfindungsgemäße Phasenregeschleife mit Kondensator.

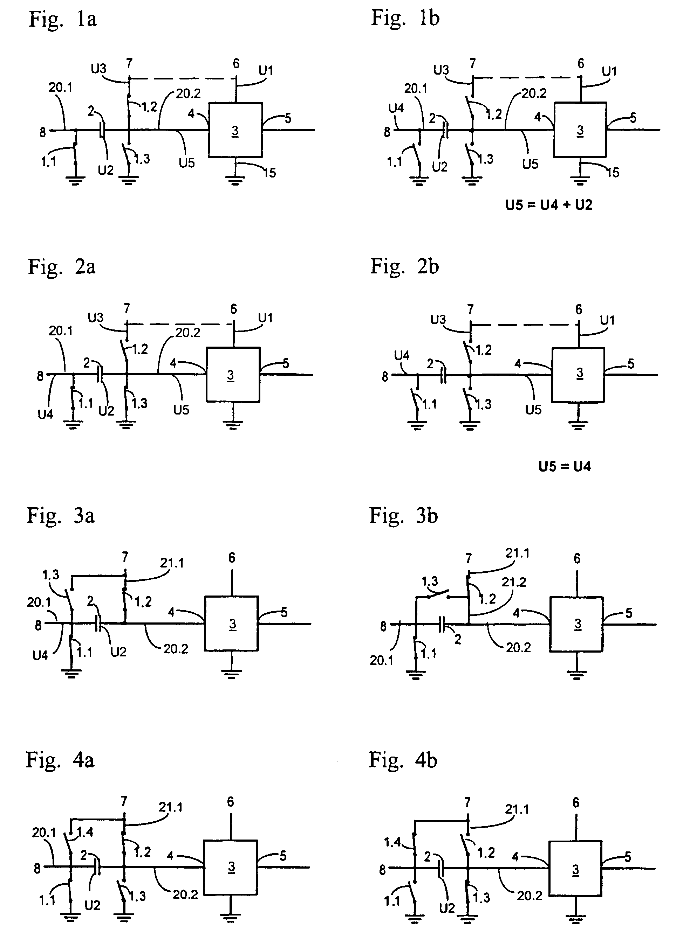

Die Figur 1a zeigt eine erfindungsgemäße elektrische Schaltungsanordnung in einer Bereitstellungsphase, wobei der Kondensator 2 geladen wird (Vorladung). Die Schaltungsanordnung besteht aus einem Schaltungseingang 8, einem Eingang 7 für eine Ladespannung U3 sowie einem Oszillator 3, mit einem Steuereingang 4 für eine Steuerspannung U5, einem HF-Ausgang 5, einer Leitung zur Erde 15 und einem Eingang 6 für eine Betriebsspannung U1. Weiterhin besteht die Schaltungsanordnung aus drei Schaltern 1.1 bis 1.3. Der Kondensator 2 ist zwischen dem Schaltungseingang 8 und dem Steuereingang 4 des Oszillators 3 angeordnet.

Zwischen dem Schaltungseingang 8 und dem Kondensator 2 verläuft eine schaltungseingangsseitige Leitung 20.1, zwischen dem Kondensator 2 und dem Steuereingang 4 des Oszillators 3 eine oszillatorseitige Leitung 20.2. Der Schalter 1.2 verbindet den Eingang 7 mit der Leitung 20.2, der Schalter 1.1 die Erde mit der Leitung 20.1 und der Schalter 1.3 die Erde mit der Leitung 20.2.

In der Bereitstellungsphase wird der Kondensator 2 durch die an dem Eingang 7 anliegenden Ladespannung U3 geladen, wobei die Schalter 1.1 und 1.2 geschlossen, der Schalter 1.3 geöffnet ist. Die Ladespannung U3 ist hier gleich der Betriebsspannung U1 (2,8 V), dargestellt durch die gestrichelte Linie zwischen den Eingängen 7 und 6. Am Ende der Bereitstellungsphase trägt der Kondensator 2 eine Zusatzspannung U2 (2,8 V), die gleich der Ladespannung U3 ist.

Es versteht sich, daß die Ladespannung U3 nicht gleich der Betriebsspannung U1 sein muß, sondern einen anderen Wert aufweisen kann, wenn zum Beispiel eine zweite Betriebsspannung zur Verfügung gestellt wird.

Die Figur 1b zeigt die erfindungsgemäße elektrische Schaltungsanordnung in einer Betriebsphase nach Vorladung des Kondensators 2. Alle Schalter 1.1 bis 1.3 sind geöffnet und am Schaltungseingang 8 liegt eine Steuerspannung U4 (0,3 V bis 2,2 V) an. Die Zusatzspannung U2 (2,8 V) des Kondensators 2 addiert sich zur eingehenden Steuerspannung U4, so daß nun die Steuerspannung U5 am Steuereingang 4 des Oszillators 3 um den Betrag der Zusatzspannung U2 höher ist als die Steuerspannung U4 am Schaltungseingang 8. Die Steuerspannung U5 hat demnach Werte zwischen 3,1 V bis 5 V.

Da der Oszillator 3 abhängig von der Steuerspannung U5 die Frequenz an seinem HF-Ausgang 5 ändert, kann durch die Erhöhung der Steuerspannung U5 der Ziehbereich des Oszillators 3, also die Größe seines abstimmbaren Frequenzbereiches, erweitert werden.

Ist nicht eine hohe, sondern eine niedrige Steuerspannung U5 am Oszillator 3 gewünscht, so verfährt man, wie in den Figuren 2a und 2b dargestellt.

Die Figur 2a zeigt die erfindungsgemäße Schaltungsanordnung in der Bereitstellungsphase ohne Vorladung des Kondensators 2. Hier sind die geerdeten Schalter 1.1 und 1.3 geschlossen, und der Schalter 1.2 geöffnet, so daß der Kondensator 2 ungeladen bleibt.

Die Figur 2b zeigt die Betriebsphase der Schaltungsanordnung, ohne daß der Kondensator 2 zuvor geladen wurde. Hier hat die Steuerspannung U5 am Steuereingang 4 des Oszillators 3 den selben Wert wie die Steuerspannung U4 am Schaltungseingang 8, nämlich 0,3 V bis 2,2 V.

Wird die Schaltung aus den Figuren 1a, 1b, 2a und 2b mit der Steuerspannung U4 von 0,3 V bis 2,2 V und einer Betriebsspannung U1 und einer Ladespannung U3 von jeweils 2,8 V betrieben, so ergibt sich am Steuereingang 4 des Oszillators 3 die Steuerspannung U5 von 0,3 V bis 2,2 V ohne Vorladung des Kondensators 2 und 3,1 V bis 5 V mit Vorladung. Hierdurch entsteht eine Lücke von 2,2 V bis 3.1 V, die nicht abgedeckt ist.

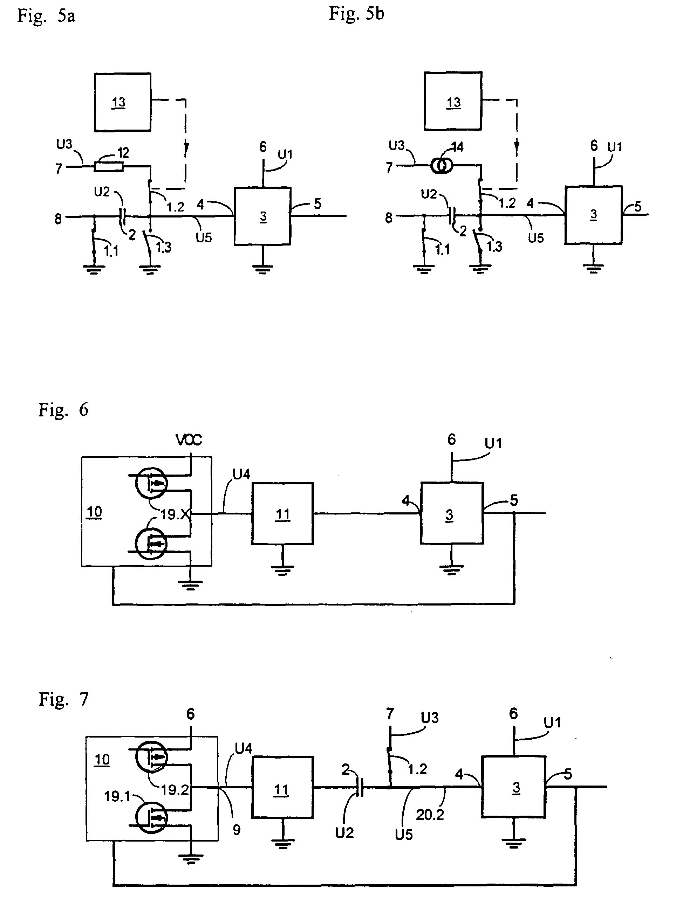

Behebbar ist diese Lücke durch die Wahl einer Ladespannung U3, die kleiner oder gleich 1,9 V ist. Da es aber unerwünscht sein kann, eine weitere Betriebsspannung U1 zur Verfügung zu stellen, wird die Figur 1a so weitergebildet, wie in den Figuren 5a und 5b gezeigt ist.

Die Figuren 3a und 3b zeigen alternative Ausführungsbeispiele der erfindungsgemäßen Schaltungsanordnung, die das gleiche leisten können wie die Schaltungsanordnungen der voranstehenden Figuren. In den Figuren 3a und 3b sind die Schaltstellungen in der Bereitstellungsphase dargestellt.

In der Figur 3a verbindet der Schalter 1.1 die Erde mit der schaltungseingangsseitigen Leitung 20.1, der Schalter 1.2 verbindet den Eingang 7 mit der oszillatorseitigen Leitung 20.2 und der Schalter 1.3 verbindet die Leitung 20.1 mit der Leitung 21.1; die zwischen dem Schalter 1.2 und dem Eingang 7 verläuft. Zur Aufladung des Kondensators 2 auf eine Zusatzspannung U2 sind die Schalter 1.1 und 1.2 geschlossen, der Schalter 1.3 ist geöffnet.

In einer anschließenden Betriebsphase werden alle Schalter 1.1 bis 1.3 geöffnet, so daß die am Kondensator 2 anliegende Zusatzspannung U2 zu der Steuerspannung U4 addiert wird.

Auch in der Figur 3b verbindet der Schalter 1.1 die Erde mit der Leitung 20.1, der Schalter 1.2 den Eingang 7 mit der Leitung 20.2. Hier verbindet nun der Schalter 1.3 die Leitung 20.1 mit der Leitung 21.2, die zwischen dem Schalter 1.2 und der Leitung 20.2 verläuft. Wie in der Figur 3a sind die Schalter 1.1 und 1.2 zur Aufladung des Kondensators 2 geschlossen und der Schalter 1.3 ist geöffnet.

Soll der Kondensator 2 entladen werden, wird dies durch Öffnen des Schalters 1.2 und Schließen des Schalters 1.3 erreicht.

Die Figuren 4a und 4b zeigen zwei Ausführungsbeispiele einer sogenannten "Vollbrücke" mit den vier Schaltern 1.1 bis 1.4.

In der Figur 4a verbindet der Schalter 1.1 die Erde mit der Leitung 20.1, der parallel hierzu angeordnete Schalter 1.3 die Erde mit der Leitung 20.2 und der Schalter 1.2 den Eingang 7 mit der Leitung 20.2. Die Verbindung zwischen der Leitung 20.1 und der Leitung 21.1 wird über den Schalter 1.4 hergestellt. Sind die Schalter 1.3 und 1.4 geöffnet und die Schalter 1.1 und 1.2 geschlossen, wird der Kondensator 2 auf eine positive Zusatzspannung U2 aufgeladen, wie dies in der Figur 4a gezeigt ist.

Die Vollbrücke in der Figur 4b ermöglicht hingegen eine Aufladung des Kondensators auf negative Zusatzspannungen U2. Die Anordnung der Schalter 1.1 bis 1.4 ist analog zu der Schalteranordnung in der Figur 4a, wobei nun die Schalter 1.2 und 1.1 geöffnet und die Schalter 1.3 und 1.4 geschlossen sind.

In einer auf die Bereitstellungsphase folgenden Betriebsphase werden sowohl in der Figur 4a als auch in der Figur 4b alle Schalter 1.1 bis 1.4 geöffnet.

Die Figur 5a zeigt ein bevorzugtes Ausführungsbeispiel der erfindungsgemäßen Schaltungsanordnung, bei der die Zusatzspannung U2 am Kondensator 2 variabel eingestellt werden kann.

Im Unterschied zu Figur 1a ist zwischen dem Eingang 7 für die Ladespannung U3 und dem Schalter 1.2 ein Widerstand 12 enthalten. Weiterhin verfügt die Schaltungsanordnung über eine Steuerung 13, die den Schalter 1.2 öffnen und schließen kann, dargestellt durch die gestrichelte Linie. Die Ladung des Kondensators 2 erfolgt nun ausgehend von der an dem Eingang 7 anliegenden Ladespannung U3 über den Widerstand 12. Wie in der Figur 1a sind die Schalter 1.2 und 1.1 geschlossen, der Schalter 1.3 geöffnet. Nach einer vorbestimmten Ladezeit öffnet die Steuerung 13 den Schalter 1.2 und beendet damit den Ladevorgang am Kondensator 2. In der anschließenden Betriebsphase sind alle Schalter 1.1 bis 1.3 geöffnet.

Diese bevorzugte Ausführung ermöglicht es, Zusatzspannungen U2 am Kondensator 2 zu erzeugen, die zwischen 0 V und der Ladespannung U3 beziehungsweise der Betriebsspannung U1 liegen. Werden Zusatzspannungen U2 zwischen 0,1 V und 0,9 V erzeugt, kann die in den Figuren 1a bis 2b aufgetretene Lücke von 2,2 V bis 3.1 V der Steuerspannung U5 am Eingang 4 des Oszillators 3 abgedeckt werden.

Figur 5b zeigt eine andere erfindungsgemäße Schaltungsanordnung, wobei der Widerstand 12 aus der Figur 5a durch eine Stromquelle ersetzt wird.

Die Figur 6 zeigt den Aufbau einer herkömmlichen Phasenregelschleife. Bei einer Phasenregelschleife wird mit Hilfe einer Filteranordnung 11 (beispielsweise eines Schleifenfilters), eines Phasen-Frequenz-Detektors 10, eines Oszillators 3, der einen Steuereingang 4, einen Eingang 6 für die Betriebsspannung U1 und einen HF-Ausgang 5 aufweist und eines Frequenzteilers (hier nicht dargestellt) die Ausgangsfrequenz des Oszillators 3 in eine phasenstarre Beziehung zu einer Referenzfrequenz gesetzt.

Der Detektor 10 erzeugt eine Steuerspannung U4. Diese durchläuft die Filteranordnung 11 und erreicht den Steuereingang 4 des Oszillators 3. Je nach Größe der Steuerspannung U4 wird eine Ausgangsfrequenz generiert, die über den Frequenzteiler dem Detektor 10 wieder zugeführt wird. Dieser vergleicht dann die Ausgangsfrequenz mit der Referenzfrequenz und regelt die Steuerspannung U4 entsprechend.

Als Detektor 10 ist hier ein Phasendetektor gezeigt, der zwei Transistoren 19.X (Charge-Pump-Transistoren) aufweist. Der Ausgang dieses Detektors 10 hat Stromquelleneigenschaften, wobei die Transistoren 19.X die Stromquellen nachbilden. Andere Varianten für einen Detektor 10 wären beispielsweise eine einfacher Analogmischer, ein EXOR-Gatter oder ein Ringmischer.

Die Figur 7 zeigt ein bevorzugtes Ausführungsbeispiel der erfindungsgemäßen Phasenregelschleife, die eine Weiterbildung der herkömmlichen Phasenregelschleife aus der Figur 6 darstellt. Hierbei ist zwischen der Filteranordnung 11 und dem Steuereingang 4 des Oszillators 3 ein Kondensator 2 angeordnet. Der Kondensator 2 kann auch vor der Filteranordnung 11 angeordnet sein, allerdings sind bei dieser Variante relativ große Kapazitätswerte an dem Kondensator 2 erforderlich.

Weiterhin verbindet ein Schalter 1.2 den Eingang 7 für die Ladespannung U3 mit der oszillatorseitigen Leitung 20.2 zwischen dem Kondensator 2 und dem Oszillator 3. Die Filteranordnung 11 ist hier als Loopfilter (Schleifenfilter) ausgebildet, das normalerweise für Gleichspannungen durchlässig ist.

Als Filteranordnung 11 wird vorzugsweise ein passives Schleifenfilter (Kondensator) eingesetzt, das Konstantstromquellen aufweist, die das Filter 11 auf- oder entladen. Um eine bessere Störunterdrückung zu erreichen, führt man eine hierdurch erzeugte Abstimmspannung noch über einen RC-Tiefpaß-Filter. Das Schleifenfilter 11 hat daher eventuell einen Serienwiderstand (DC-Widerstand), der die Funktion der Schaltung in der Figur 7 aber nicht stört, wenn er hinreichend klein ist. Dies bedeutet, der DC-Widerstand sollte so klein sein, daß es in der Bereitstellungsphase möglich wird, trotz des DC-Widerstandes den Kondensator 2 völlig zu laden.

Der Ausgang 9 des Phasen-Frequenz-Detektors 10 verfügt über zwei komplementär angeordnete Transistoren 19.1 und 19.2 (Charge-Pump-Transistoren), also beispielsweise zwei MOS-Fets. Jeder einzelne dieser MOS-Fets kann, falls gewünscht, beliebig geöffnet oder geschlossen werden. Somit können diese Transistoren 19.X bei geeigneter Steuerung in der Bereitstellungsphase die Funktion des Schalters 1.1 aus den Figuren 1a und 2a beziehungsweise die Funktion der Schalter 1.1 und 1.3 aus den Figuren 3a und 3b übernehmen.

Um den Kondensator 2 auf die Zusatzspannung U2 aufzuladen, ist in der Bereitstellungsphase der Schalter 1.2 sowie der Transistor 19.1 geschlossen. Der Transistor 19.2 dagegen ist geöffnet.

In der Betriebsphase ist der Schalter 1.2 geöffnet, die Transistoren 19.1 und 19.2 arbeiten als normaler Phasendetektor und die Zusatzspannung U2 addiert sich zu der von dem Detektor 10 ausgegebenen Steuerspannung U4. Am Eingang 4 des Oszillators 3 liegt nun die Steuerspannung U5 an, die sich aus der Zusatzspannung U2 und der Steuerspannung U4 zusammensetzt. Die Transistoren 19.1 und 19.2 arbeiten in dieser Betriebsphase also wieder normal als Phasendetektor.

Es versteht sich, daß anstelle eines Detektors 10 mit Transistoren 19.X auch andere Phasendetektoren eingesetzt werden können, wie zum Beispiel ein Mischer, der keine Ausgangstransistoren 19.X besitzt. Erfindungsgemäß können sich dann eine der voranstehend beschriebenen erfindungsgemäßen Schaltungsanordnungen aus den Figuren 1a bis 5b zwischen dem Phasendetektor und dem Oszillator 3 befinden, mit derer Hilfe die Steuerspannung U5 an dem Steuereingang 4 des Oszillators 3 erhöht wird. In diesem Fall kann nun als Filteranordnung 11 auch ein aktiver Schleifenfilter verwendet werden.

Es versteht sich, daß die vorstehend genannten Merkmale der Erfindung nicht nur in der jeweils angegebenen Kombination, sondern auch in anderen Kombinationen oder in Alleinstellung verwendbar sind, ohne den Rahmen der Erfindung zu verlassen.

Insgesamt wird durch die Erfindung ein Verfahren zur Verfügung gestellt, das auf einfache und störungsfreie Weise eine Erweiterung des Ziehbereichs eines Oszillators ermöglicht. Weiterhin wird eine elektrische Schaltungsanordnung und eine Phasenregelschleife zur Durchführung des Verfahrens vorgestellt.

### Bezugszeichenliste

- 1.X: Schaltmittel
- 2: Kondensator
- 3: Oszillator
- 4: Steuereingang
- 5: HF-Ausgang
- 6: Eingang für die Betriebsspannung U1
- 7: Eingang für die Ladespannung U3
- 8: Schaltungseingang
- 9: Ausgang des Detektors 10
- 10: Detektor
- 11: Filteranordnung
- 12: Widerstand
- 13: Steuervorrichtung
- 14: Stromquelle
- 15: Leitung zur Erde
- 19.X: Transistor
- 20.1: Schaltungseingangsseitige Leitung
- 20.2: Oszillatorseitige Leitung
- 21.1: Leitung zwischen Schalter 1.2 und Eingang 7
- 21.2: Leitung zwischen Schalter 1.2 und Leitung 20.2

- U1: Betriebsspannung
- U2: Zusatzspannung
- U3: Ladespannung
- U4: Steuerspannung
- U5: Steuerspannung

## Patentansprüche

1. Verfahren zum Betrieb eines spannungsgesteuerten Oszillators (3), insbesondere in einem portablen Kommunikationsgerät, wobei dem Oszillator (3) eine variable Steuerspannung (U4) zugeführt wird, die einer Betriebsspannung (U1), vorzugsweise aus einer konstanten Spannungsquelle, entnommen wird, **dadurch gekennzeichnet, daß** die variable Steuerspannung (U4) über einen Kondensator (2) dem Oszillator (3) zugeführt wird, und der variablen Steuerspannung (U4) in einer Betriebsphase bei Bedarf eine bestimmte Zusatzspannung (U2) zuaddiert wird, wobei die bestimmte Zusatzspannung (U2) in einer Bereitstellungsphase auf den Kondensator (2) aufgebracht wird.

2. Verfahren gemäß dem voranstehenden Anspruch 1, **dadurch gekennzeichnet, daß** der Kondensator (2) während der Bereitstellungsphase mit Hilfe einer an dem Kondensator (2) anliegenden Ladespannung (U3), die gleich der Betriebsspannung (U1) sein kann, aufgeladen wird.

3. Verfahren gemäß dem voranstehenden Anspruch 2, **dadurch gekennzeichnet, daß** die bestimmte Zusatzspannung (U2) des Kondensators (2) durch Unterbrechung der Ladespannung (U3) des Kondensators (2) gesteuert wird.

4. Verfahren gemäß einem der voranstehenden Ansprüche 2 oder 3, **dadurch gekennzeichnet, daß** die Zusatzspannung (U2) gegenläufig der Ladespannung (U3) ausgebildet ist.

5. Verfahren gemäß einem der voranstehenden Ansprüche 1 bis 4, **dadurch gekennzeichnet, daß** der Kondensator (2) während der Bereitstellungsphase entladen wird.

6. Verfahren gemäß einem der voranstehenden Ansprüche 1 bis 5, **dadurch gekennzeichnet, daß** der Kondensator (2) während der Betriebsphase weder geladen noch entladen wird.

7. Verfahren gemäß einem der voranstehenden Ansprüche 1 bis 6, **dadurch gekennzeichnet, daß** der spannungsgesteuerte Oszillator (3) in einer Phasenregelschleife verwendet wird.

8. Elektrische Schaltungsanordnung zur Steuerung eines spannungsgesteuerten Oszillators (3), wobei der Oszillator (3) mindestens einen Steuereingang (4) für eine variable Steuerspannung (U4) und mindestens einen Eingang (6) für eine Betriebsspannung (U1) aufweist, **dadurch gekennzeichnet, daß** ein Kondensator (2) in Serie zu dem Steuereingang (4) des Oszillators (3) vorgesehen ist, der mittels zumindest eines Schaltmittels (1.x) zur Vorladung in einer Bereitstellungsphase an eine Ladespannung (U3) anschließbar ist und in einer Betriebsphase seine Spannung als eine Zusatzspannung (U2) an den Steuereingang (4) des Oszillators (3) legt.

9. Elektrische Schaltungsanordnung gemäß dem voranstehenden Anspruch 8, **dadurch gekennzeichnet, daß** zur Vorladung des Kondensators (2) mindestens drei, gegebenenfalls vier Schaltmittel (1.X) vorgesehen sind.

10. Elektrische Schaltungsanordnung gemäß einem der voranstehenden Ansprüche 8 bis 9, **dadurch gekennzeichnet, daß** zumindest ein Schaltmittel (1.X) mindestens ein Transistor und/oder mindestens eine Diode und/oder mindestens ein Schalter ist.

11. Elektrische Schaltungsanordnung gemäß einem der voranstehenden Ansprüche 8 bis 10, **dadurch gekennzeichnet, daß** eine Steuervorrichtung (13) zur Betätigung von mindestens einem Schaltmittel (1.X) vorgesehen ist.

12. Elektrische Schaltungsanordnung gemäß dem voranstehenden Anspruch 11, **dadurch gekennzeichnet, daß** die Steuervorrichtung (13) derart ausgebildet ist, daß die Ladezeit variiert werden kann.

13. Phasenregelschleife mit mindestens einem Detektor (10), der eine variable Steuerspannung (U4) erzeugt, einer Filteranordnung (11) und einem Oszillator (3), wobei der Oszillator (3) mindestens einen Steuereingang (4) für die variable Steuerspannung (U4) und mindestens einen Eingang (6) für eine Betriebsspannung (U1) aufweist, **dadurch gekennzeichnet, daß** vor dem Steuereingang (4) eine elektrische Schaltungsanordnung, gemäß einem der voranstehenden Ansprüche 8 bis 12, vorgesehen ist.

14. Phasenregelschleife gemäß dem voranstehenden Anspruch 13, **dadurch gekennzeichnet, daß** der Detektor (10) zwei komplementär angeordnete Transistoren aufweist, die in einer Bereitstellungsphase als zwei Schaltmittel (1.X) fungieren.

## Claims

1. Method for operating a voltage controlled oscillator (3), in particular in a portable communications appliance, with the oscillator (3) being supplied with a variable control voltage (U4) which is taken from an operating voltage (U1), preferably from a constant voltage source, **characterized in that** the variable control voltage (U4) is supplied via a capacitor (2) to the oscillator (3), and a specific additional voltage (U2) is added to the variable control voltage (U4) when required in an operating phase, with the specific additional voltage (U2) being applied to the capacitor (2) in a preparation phase.

2. Method according to the preceding claim 1, **characterized in that** the capacitor (2) is charged during the preparation phase with the aid of a charging voltage (U3) which is applied to the capacitor (2) and may be equal to the operating voltage (U1).

3. Method according to the preceding claim 2, **characterized in that** the specific additional voltage (U2) of the capacitor (2) is controlled by interrupting the charging voltage (U3) for the capacitor (2).

4. Method according to one of the preceding claims 2 or 3, **characterized in that** the additional voltage (U2) is formed in the opposite sense to the charging voltage (U3).

5. Method according to one of the preceding claims 1 to 4, **characterized in that** the capacitor (2) is discharged during the preparation phase.

6. Method according to one of the preceding claims 1 to 5, **characterized in that** the capacitor (2) is neither charged nor discharged during the operating phase.

7. Method according to one of the preceding claims 1 to 6, **characterized in that** the voltage controlled oscillator (3) is used in a phased locked loop.

8. Electrical circuit arrangement for controlling a voltage controlled oscillator (3), with the oscillator (3) having at least one control input (4) for a variable control voltage (U4) and at least one input (6) for an operating voltage (U1), **characterized in that** the capacitor (2) is provided in series with the control input (4) of the oscillator (3) which can be connected to a charging voltage (U3) by at least one switching means (1.X) for precharging in a preparation phase and adding its voltage as an additional voltage (U2) to the control input (4) of the oscillator (3) in an operating phase.

9. Electrical circuit arrangement according to the preceding claim 8, **characterized in that** at least three, and possibly four, switching means (1,X) are provided for precharging the capacitor.

10. Electrical circuit arrangement according to one of the preceding claims 8 and 9, **characterized in that** at least one switching means (1.X) is at least one transistor and/or at least one diode and/or at least one switch.

11. Electrical circuit arrangement according to one of the preceding claims 8 to 10, **characterized in that** a control apparatus (13) is provided for operating at least one switching means (1.X).

12. Electrical circuit arrangement according to the preceding claim 11, **characterized in that** the control apparatus (13) is designed such that the charging time can be varied.

13. Phase locked loop having at least one detector (10) which produces a variable control voltage (U4), having a filter arrangement (11) and having an oscillator (3), with the oscillator (3) having at least one control input (4) for the variable control voltage (U4) and at least one input (6) for an operating voltage (U1), **characterized in that** an electrical circuit arrangement according to one of the preceding claims 8 to 12 is provided upstream of the control input (4).

14. Phased locked loop according to the preceding claim 13, **characterized in that** the detector (10) has two complimentary arranged transistors, which act as two switching means (1.X) in a preparation phase.

## Revendications

1. Procédé permettant de faire fonctionner un oscillateur asservi en tension (3), notamment dans un appareil de communication portable, une tension de commande variable (U4) prélevée d'une tension de service (U1), émanant de préférence d'une source de tension constante, étant appliquée à l'oscillateur (3), **caractérisé en ce que** la tension de commande variable (U4) est appliquée à l'oscillateur (3) par l'intermédiaire d'un condensateur (2) et une tension supplémentaire (U2) déterminée est additionnée en cas de besoin à la tension de commande variable (U4) au cours d'une phase de service, la tension supplémentaire (U2) déterminée étant appliquée au condensateur (2) au cours d'une phase de préparation.

2. Procédé suivant la revendication 1 précédente, **caractérisé en ce que** pendant la phase de préparation, le condensateur (2) est chargé à l'aide d'une tension de charge (U3) appliquée au condensateur (2), qui peut être égale à la tension de service (U1).

3. Procédé suivant la revendication 2 précédente, **caractérisé en ce que** la tension supplémentaire (U2) déterminée du condensateur (2) est réglée par interruption de la tension de charge (U3) du condensateur (2).

4. Procédé suivant l'une quelconque des revendications précédentes 2 ou 3, **caractérisé en ce que** la tension supplémentaire (U2) est de sens opposé à la tension de charge (U3).

5. Procédé suivant l'une quelconque des revendications précédentes 1 à 4, **caractérisé en ce que** le condensateur (2) est déchargé pendant la phase de préparation.

6. Procédé suivant l'une quelconque des revendications précédentes 1 à 5, **caractérisé en ce que** pendant la phase de service, le condensateur (2) n'est ni chargé, ni déchargé.

7. Procédé suivant l'une quelconque des revendications précédentes 1 à 6, **caractérisé en ce que** l'oscillateur asservi en tension (3) est utilisé dans une boucle à phase asservie.

8. Agencement de circuit électrique pour commander un oscillateur asservi en tension (3), l'oscillateur (3) comportant au moins une entrée de commande (4) pour une tension de commande variable (U4) et au moins une entrée (6) pour une tension de service (U1), **caractérisé en ce qu'**il est prévu en série par rapport à l'entrée de commande (4) de l'oscillateur (3) un condensateur (2), qui à l'aide d'au moins un moyen de commutation (1.x) peut se brancher au cours d'une phase de préparation sur une tension de charge (U3) et qui au cours d'une phase de service applique sa tension en tant que tension supplémentaire (U2) à l'entrée de commande (4) de l'oscillateur (3).

9. Agencement de circuit électrique suivant la revendication 8 précédente, **caractérisé en ce qu'**il est prévu au moins trois, le cas échéant, quatre moyens de commutation (1.X).

10. Agencement de circuit électrique suivant l'une quelconque des revendications précédentes 8 à 9, **caractérisé en ce qu'**au moins un moyen de commutation (1.X) est au moins un transistor et/ou au moins une diode et/ou au moins un interrupteur.

11. Agencement de circuit électrique suivant l'une quelconque des revendications précédentes 8 à 10, **caractérisé en ce qu'**on a prévu un dispositif de commande (13) pour actionner au moins un moyen de commutation (1.X).

12. Agencement de circuit électrique suivant la revendication 11 précédente, **caractérisé en ce que** le dispositif de commande (13) est conçu de façon à permettre de faire varier le temps de charge.

13. Boucle à phase asservie ayant au moins un détecteur (10), qui génère une tension de commande variable (U4), un ensemble de filtres (11) et un oscillateur (3), l'oscillateur (3) comportant au moins une entrée de commande (4) pour la tension de commande variable (U4) et au moins une entrée (6) pour une tension de service (U1), **caractérisée en ce qu'**en amont de l'entrée de commande (4), il est prévu un agencement de circuit électrique suivant l'une quelconque des revendications précédentes 8 à 12.

14. Boucle à phase asservie suivant la revendication 13 précédente, **caractérisée en ce que** le détecteur (10) comporte deux transistors disposés de façon complémentaire, qui au cours d'une phase de préparation fonctionnent comme deux moyens de commutation (1.X).
